# EUROPEAN PATENT APPLICATION

(11) **EP 4 734 705 A1**
(43) Date of publication of application: **29.04.2026**
(21) Application number: 23947310.1
(22) Date of filing: 30.10.2023
(51) Int. Cl.: H10F 19/80, H10F 71/10

(54) **STACKED STRUCTURE, PHOTOVOLTAIC MODULE AND MANUFACTURING METHOD THEREFOR**

(30) Priority: 31.07.2023 CN 202310948983
(71) Applicant: Shanghai Ja Solar Technology Co., Ltd., Shanghai 201401 (CN); Ja Solar Technology Yangzhou Co., Ltd., Yangzhou, Jiangsu 225131 (CN)
(72) Inventor: CHEN, Daoyuan, Yangzhou, Jiangsu 225131 (CN); YU, Lailing, Yangzhou, Jiangsu 225131 (CN); WANG, Ying, Yangzhou, Jiangsu 225131 (CN)
(74) Representative: Sun, Yiming
(86) International application number: PCT/CN2023/127734
(87) International publication number: WO 2025/025371

(57) **Abstract**

The present disclosure relates to a stacked structure, a photovoltaic module and a manufacturing method thereof. The method for manufacturing a photovoltaic module comprises: manufacturing a cell string unit; providing a cover plate and laying a first encapsulation layer on one side of the cover plate; laying the cell string unit on one side of the first encapsulation layer away from the cover plate; laying a second encapsulation layer on one side of the cell string unit away from the first encapsulation layer; laying a back plate on one side of the second encapsulation layer away from the cell string unit to obtain a stacked structure; laminating the stacked structure to obtain a laminated member; mounting a frame and a junction box on the laminated member to obtain a photovoltaic module; wherein the manufacturing of a cell string unit includes: providing a cell string; laying an adhesive film strip on a surface of the cell string; and heat-crosslinking the cell string laid with the adhesive film strip to obtain a cell string unit. By the manufacturing method, the adhesive film strip will not melt again during lamination, which prevents relative displacement of the cells and thereby avoids non-uniform string spacing of the cell strings.

## Description

### CROSS REFERENCE TO RELATED APPLICATIONS

The present application claims the priority of the Chinese patent application No. 202310948983.0 filed on July 31, 2023, the disclosure of which is hereby incorporated by reference in its entirety.

### TECHNICAL FIELD

The present disclosure relates to the technical field of a solar module, in particular a stacked structure, a photovoltaic module, and a manufacturing method thereof.

### BACKGROUND

With an increase in the size of solar cells, the production of solar batteries increases, which at the same time leads to a reduction in costs and an increase in series losses as well as hot spot problems. Therefore, solar cells need to be cut into smaller sizes through multiple cuts, such as five or six cuts, before they are encapsulated. However, due to an increase in the number of cells in a cell string, displacement of cells would easily occur in a lamination process because of the shrinkage rate and flowability of encapsulation materials, thereby resulting in a problem about non-uniform string spacing.

In the prior art, adhesive tapes are used to fix cells so as to solve the problem about displacement of cells. However, in a lamination process, a problem about non-uniform string spacing of the cell strings will still occur. For this reason, technicians have adopted a method, in which the predetermined areas of a back plate encapsulation adhesive film are heated after the back plate encapsulation adhesive film is laid, such that both the predetermined areas of the back plate encapsulation adhesive film and the adhesive strips are melted and pre-crosslinked so as to pre-fix the cell strings. However, pre-crosslinking the adhesive strips by heating the predetermined areas of the back plate encapsulation film has relatively high requirements on the heating process for pre-crosslinking. In actual production, there might be a problem that sliding displacement of cells would still occur in a lamination process because requirements on the heating process are not satisfied.

Therefore, as for how to solve the sliding displacement of cells caused by the melting of adhesive strips and the resulting non-uniform string spacing of the cells, it is still a problem that urgently needs to be solved by those skilled in the art.

### SUMMARY

In view of this, there are provided a stacked structure, a photovoltaic module and a manufacturing method thereof to solve the problem in the prior art, i.e., how to solve the sliding displacement of cells caused by the melting of an adhesive strip and the resulting non-uniform string spacing of the cell strings.

On the one hand, there is provided a method for manufacturing a photovoltaic module, comprising: manufacturing a cell string unit; providing a cover plate and laying a first encapsulation layer on one side of the cover plate; laying the cell string unit on one side of the first encapsulation layer away from the cover plate; laying a second encapsulation layer on one side of the cell string unit away from the first encapsulation layer; laying a back plate on one side of the second encapsulation layer away from the cell string unit to obtain a stacked structure; laminating the stacked structure to obtain a laminated member; mounting a frame and a junction box on the laminated member to obtain a photovoltaic module; wherein the manufacturing of a cell string unit includes: providing a cell string; laying an adhesive film strip on a surface of the cell string; and heat-crosslinking the cell string laid with the adhesive film strip to obtain the cell string unit.

In one embodiment, the adhesive film strip is laid on the surface of the cell string in the middle portion along the direction of the long sides; or the adhesive film strip is laid on the surface of the cell string at the edges on both sides along the direction of the long sides; or the adhesive film strip is laid on the surface of the cell string at the edge on a single side along the direction of the long sides.

In one embodiment, the heat-crosslinking of the cell string laid with the adhesive film strip includes: heating the preset positions of the adhesive film strip to pre-fix the adhesive film strip on the surface of the cell string; and heat-crosslinking the cell string which is pre-fixed by the adhesive film strip.

In one embodiment, the manner for pre-fixing is soldering iron heating or light heating or bake-heating.

In one embodiment, the manner for heat-crosslinking is bake-crosslinking or light crosslinking.

In one embodiment, the adhesive film strip is an EVA, POE, EPE, PVB, epoxy resin film, acrylic film, or silicone film strip, and the heating time for bake-crosslinking is 8-10 minutes.

In one embodiment, the adhesive film strip is a pre-crosslinked material which preferably has a pre-crosslinking degree of 30%-50%, and the heating time for bake-crosslinking is 1-3 minutes.

In one embodiment, the adhesive film strip is a composite adhesive film strip.

On the other hand, there is provided a stacked structure, comprising: a cover plate, a first encapsulation layer, a cell string unit, a second encapsulation layer and a back plate, wherein the first encapsulation layer is disposed on one side of the cover plate; the cell string unit is disposed on one side of the first encapsulation layer away from the cover plate; the second encapsulation layer is disposed on one side of the cell string unit away from the first encapsulation layer; the back plate is disposed on one side of the second encapsulation layer away from the cell string unit, the cell string unit including a cell string and an adhesive film strip, wherein the adhesive film strip is disposed on a surface of the cell string to fix the cell string.

On the other hand, there is provided a photovoltaic module, which is manufactured by subjecting the above stacked structure to a lamination treatment to obtain a laminated member and then mounting a junction box and a frame.

Beneficial effects of the technical solution of the present disclosure:
By disposing the adhesive film strip on the surface of the cell string and subjecting the adhesive film strip to a heat-crosslinking treatment, a cell string unit in which the cell string is fixed by the adhesive film strip is obtained, and the cell string unit is then placed between the encapsulation layers of the photovoltaic module, wherein the heat-crosslinked adhesive film strip will not melt again during lamination, which prevents relative displacement of the cells and thereby avoids non-uniform string spacing of the cell strings. In particular, in this solution, the cell string laid with the adhesive film strip is directly heat-crosslinked, which enables a better crosslinking effect and makes the process simpler and more convenient.

### BRIEF DESCRIPTION OF DRAWINGS

FIG. 1 is a schematic diagram of the structure of a stacked structure disclosed in an embodiment of the present disclosure;
FIG. 2 is a flowchart of a method for manufacturing a photovoltaic module disclosed in an embodiment of the present disclosure;
FIG. 3 is a flowchart of step S10 in the manufacturing method shown in FIG. 2;
FIG. 4 is a schematic diagram of a first corresponding structure formed in step S12 of the manufacturing method shown in FIG. 3;
FIG. 5 is a schematic diagram of a second corresponding structure formed in step S12 of the manufacturing method shown in FIG. 3;
FIG. 6 is a schematic diagram of a third corresponding structure formed in step S12 of the manufacturing method shown in FIG. 3;
FIG. 7 is a schematic diagram of a corresponding structure of the adhesive film strip in step S12 of the manufacturing method shown in FIG. 3;
FIG. 8 is a flowchart of step S13 of the manufacturing method shown in FIG. 3;
FIG. 9 is a schematic diagram of a first corresponding structure formed in step S131 of the manufacturing method shown in FIG. 8;
FIG. 10 is a schematic diagram of a second corresponding structure formed in step S131 of the manufacturing method shown in FIG. 8;
FIG. 11 is a schematic diagram of a third corresponding structure formed in step S131 of the manufacturing method shown in FIG. 8;
FIG. 12 is a schematic diagram of a corresponding structure formed in step S20 of the manufacturing method shown in FIG. 2;
FIG. 13 is a schematic diagram of a corresponding structure formed in step S30 of the manufacturing method shown in FIG. 2;
FIG. 14 is a schematic diagram of a corresponding structure formed in step S40 of the manufacturing method shown in FIG. 2.

### Notes of Reference Signs

100 - Stacked structure;
110 - Cover plate;
130 - First encapsulation layer;
10 - Press bar;
160 - Cell string unit;
161 - Cell string;
162 - Shear deformation resistant material;
163 - Adhesive film strip;
180 - Second encapsulation layer;
190 - Back plate;
S10-S70 - Steps of the method of manufacturing a photovoltaic module;
S11-S13 - Steps of a method of manufacturing a cell string unit;
S131-S132 - Steps of heat-crosslinking the cell string.

### DETAILED DESCRIPTION

To make the objectives, technical solutions and advantages of the present disclosure clearer, the present disclosure will be further explained in details below with reference to the drawings and embodiments. It should be understood that the specific embodiments described herein are only for the purpose of illustrating the present disclosure and are not intended to limit the present disclosure.

It should be noted that the drawings provided in the embodiments are only schematic illustrations of the basic concept of the present disclosure. Therefore, the drawings only show components related to the present disclosure, but are not made according to the numbers, shapes and sizes of the components in practical implementation. In practical implementation, the forms, numbers and proportions of the respective components can be arbitrarily changed, and the layouts of the components may also be more complex. The structures, proportions, sizes and the like shown in the accompanying drawings of the specification are only for the purpose of assisting those skilled in the art in understanding and reading the contents disclosed herein, and are not intended to limit the conditions under which the present disclosure can be implemented, and therefore do not have any substantive technical significance. Any modifications to the structures, changes in the proportions, or adjustments to the sizes, without affecting the effects and objectives that can be achieved by this disclosure, should still fall within the scope of the technical contents disclosed herein. Meanwhile, the terms such as "upper", "lower", "left", "right", "middle", and "one" used in this specification are merely for clarity of description and are not intended to limit the implementation scope of the present disclosure, and any changes or adjustments made to the relative relationships thereof without substantively changing the technical contents should also be considered as falling within the implementation scope of the present disclosure.

With an increase in the size of solar cells, the production of solar cells increases, which at the same time leads to a reduction in costs and an increase in series losses as well as hot spot problems. Therefore, solar cells need to be cut into smaller sizes through multiple cuts, such as five or six cuts, before they are encapsulated. However, there are usually gaps between solar cells, a problem about displacement of cells would easily occur because of the shrinkage rate and flowability of encapsulation materials in a lamination process. In the prior art, adhesive tapes are used to fix cell strings so as to solve the problem about displacement of cells. However, in a lamination process, a problem about non-uniform string spacing of the cell strings will still occur. For this reason, technicians have adopted a method, in which the predetermined areas of a back plate encapsulation adhesive film are heated after the back plate encapsulation adhesive film is laid, such that both the predetermined areas of the back plate encapsulation adhesive film and the adhesive strips are melted and pre-crosslinked so as to pre-fix the cell strings. However, pre-crosslinking the adhesive strips by heating the predetermined areas of the back plate encapsulation film has relatively high requirements on the heating process for pre-crosslinking. In actual production, there might be a problem that sliding displacement of cells would still occur in a lamination process because requirements on the heating process are not satisfied. Therefore, as for how to solve the sliding displacement of cells caused by the melting of adhesive strips and the resulting non-uniform string spacing of the cell strings, it is still a problem that urgently needs to be solved by those skilled in the art.

In view of this, the present disclosure aims to provide a solution which can solve the above technical problem, i.e., can solve the problem about the sliding displacement of cells caused by the melting of adhesive strips and the resulting non-uniform string spacing of the cell strings. Details will be described in subsequent embodiments.

The solution of the present disclosure provides a detailed description of a stacked structure, a photovoltaic module, and a manufacturing method thereof.

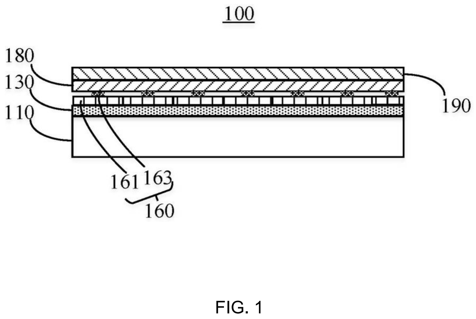

Please refer to FIG. 1, which is a schematic diagram of the structure of a stacked structure disclosed in an embodiment of the present disclosure. The present disclosure provides a stacked structure 100, comprising at least a cover plate 110, a first encapsulation layer 130, a cell string unit 160, a second encapsulation layer 180, and a back plate 190.

The first encapsulation layer 130 is disposed on one side of the cover plate 110. In this embodiment of the present disclosure, the first encapsulation layer 130 may be a solid single-layered or multi-layered adhesive film strip at room temperature, which is made of ethylene vinyl acetate copolymer (EVA) and/or polyolefin elastomer (POE) as main raw materials, and the cover plate 110 may be a glass plate that allows light to pass through the front of the photovoltaic module.

The cell string unit 160 is disposed on one side of the first encapsulation layer 130 away from the cover plate 110. The cell string unit 160 includes a cell string 161 and an adhesive film strip 163. The adhesive film strip 163 is disposed on the surface of the cell string 161, and the cell string 161 laid with the adhesive film strip 163 is heat-crosslinked to obtain the cell string unit 160 before encapsulation, wherein the heat-crosslinked adhesive film strip 163 is used to fix the cell string 161, thereby preventing relative displacement of the cells caused by the melting and the flowing of the adhesive film strip in a lamination process and the resulting problem about non-uniform string spacing.

In this embodiment of the disclosure, the adhesive film strip 163 may be an EVA, POE, expandable polyethylene (EPE), polyvinyl butyral (PVB), polypropylene (PP), epoxy resin film, acrylic film, or silicone film strip

The second encapsulation layer 180 is disposed on one side of the cell string unit 160 away from the first encapsulation layer 130. In this embodiment of the present disclosure, the second encapsulation layer 180 may be a solid single-layered or multi-layered adhesive film strip at room temperature, which is made of EVA and/or POE as main raw materials.

The back plate 190 is disposed on one side of the second encapsulation layer 180 away from the cell string unit 160.

To sum up, in the stacked structure of the present disclosure, before the stacked structure 100 is manufactured, the adhesive film strip 163 disposed on the surface of the cell string 161 is firstly crosslinked so as to fix the cells in the cell string 161, thereby preventing relative displacement of the cells caused by the melting and flowing of adhesive film strip 163 in a lamination process and the resulting problem about non-uniform string spacing.

The present disclosure also provides a photovoltaic module, which is manufactured by subjecting the stacked structure 100 in the embodiment shown in FIG. 1 to a lamination treatment to obtain a laminated member and then mounting a junction box and a frame.

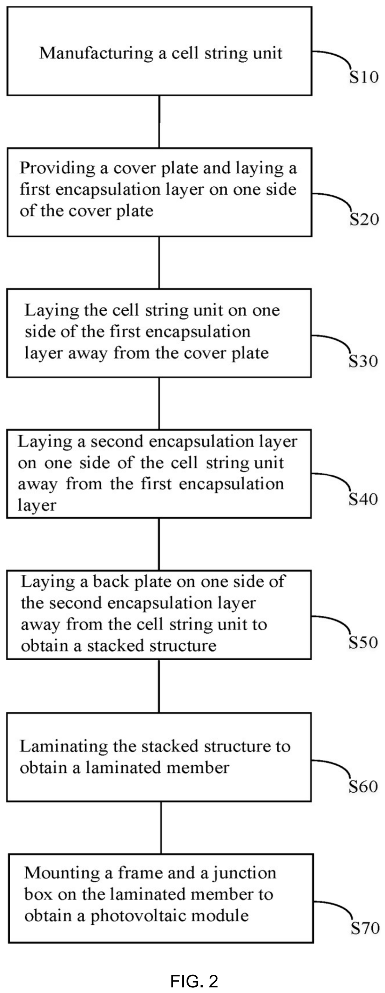

Please refer to FIG. 2, which is a flowchart of a method for manufacturing a photovoltaic module disclosed in an embodiment of the present disclosure. In this embodiment of the present disclosure, the method for manufacturing a photovoltaic module comprises at least the following steps.

S10. Manufacturing a cell string unit

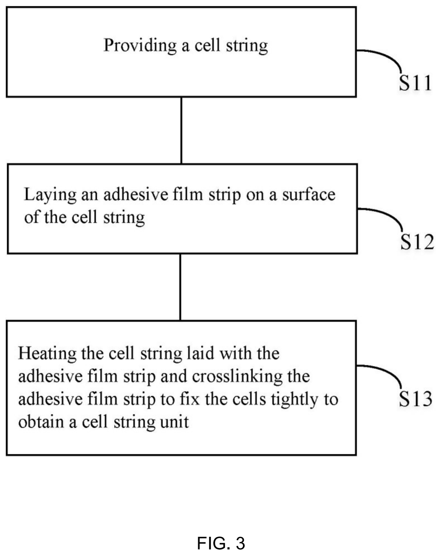

Please refer to FIG. 3. In this embodiment of the present disclosure, the step S10 includes at least the following steps.

S11. Providing a cell string

Specifically, in this embodiment of the disclosure, a cell string 161 is provided, the cell string 161 is aligned along a straight line, and the aligned cell string 161 is flattened by a press bar 10, so as to reduce the gaps between the cells, thereby preventing relative displacement between the cells.

S12. Laying an adhesive film strip on the surface of the cell string

Specifically, the adhesive film strip 163 is laid on the surface of the cell string 161, wherein the adhesive film strip 163 may be an EVA, POE, EPE, PVB, epoxy resin film, acrylic film, or silicone film strip. Specifically, the adhesive film strip 163 may be laid on the front of the cell string 161, and may be also laid on the back of the cell string 161.

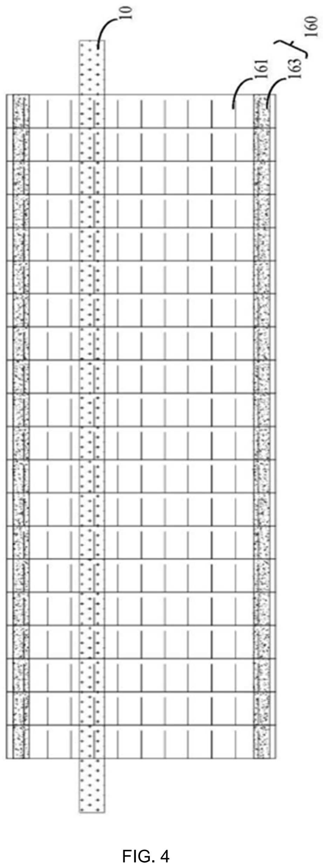

In this embodiment of the present disclosure, as shown in FIG. 4, the adhesive film strip 163 may be laid on the surface of the cell string 161 at the edges on both sides along the direction of the long sides, and the cells are fixed by heat-crosslinking the two sides thereof, thereby solving the problem about the relative displacement between two cells in a lamination process.

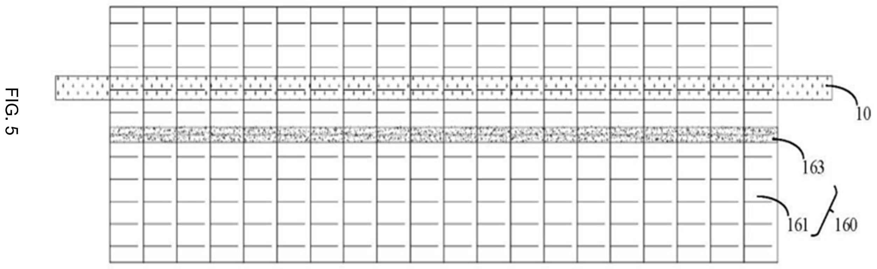

In this embodiment of the present disclosure, as shown in FIG. 5, the adhesive film strip 163 may be laid on the surface of the cell string in the middle portion along the direction of the long sides, and the cells are fixed by heat-crosslinking the middle positions thereof. This arrangement can decrease the number of the adhesive film strips to be used and reduce the costs without affecting the fixing effect of the cells.

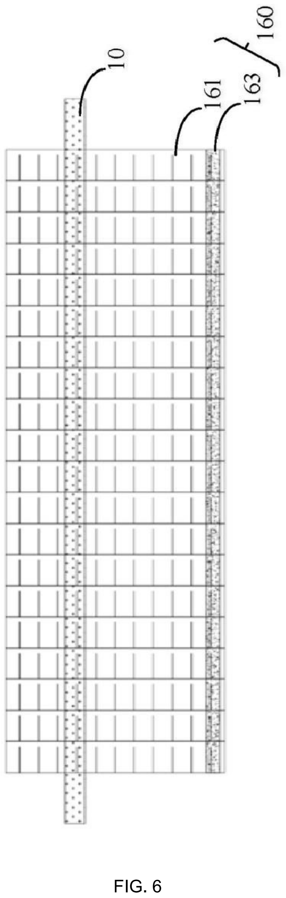

In this embodiment of the present disclosure, as shown in FIG. 6, the adhesive film strip 163 may be also laid on the surface of the cell string 161 at the edge on a single side along the direction of the long sides.

It can be understood that as long as the adhesive film strip 163 is laid in any position on the surface of the cell string 161, the adhesive film strip 163 can be crosslinked in a subsequent heat-crosslinking process to fix the cells of the cell string 161, thereby preventing the problem about non-uniform spacing of the cell cells caused by the melting and flowing of the adhesive film strip 163 in a lamination process.

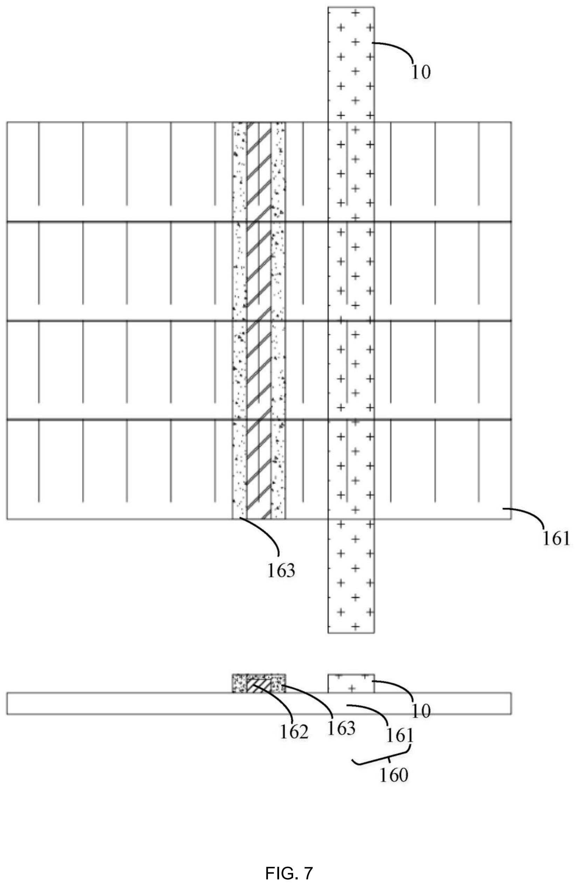

Alternatively, as shown in FIG. 7, in another embodiment, the adhesive film strip 163 may also be a composite adhesive film strip, which may be formed by disposing an adhesive film strip on the surface of a shear deformation resistant material 162, wherein the shear deformation resistant material 162 may be selected from PET, PP and PA. Alternatively, the composite adhesive film strip may be prepared by adding a shear-resistant material to an adhesive film strip material, wherein the shear resistant material is a material that can improve the shear resistance of the adhesive film strip and may be selected from glass fiber or nonwoven fabric.

Step S13. Heating the cell string laid with the adhesive film strip and crosslinking the adhesive film strip to fix the cells tightly to obtain a cell string unit

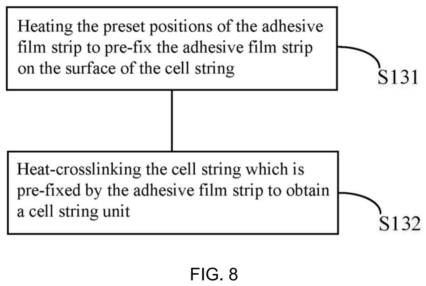

Specifically, refer to FIG. 8. In this embodiment of the present disclosure, the step S13 includes at least the following steps.

S131. Heating the preset positions of the adhesive film strip to pre-fix the adhesive film strip on the surface of the cell string

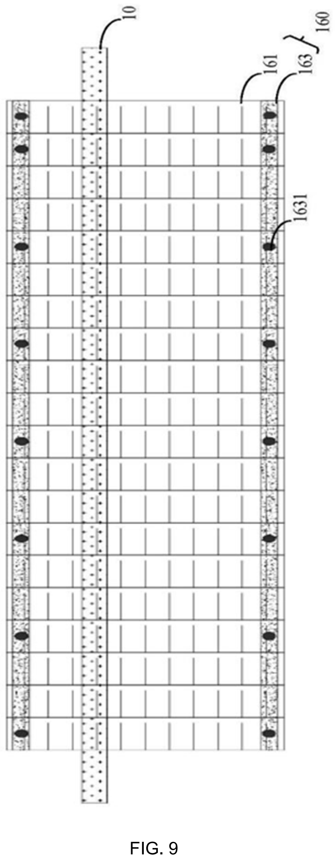

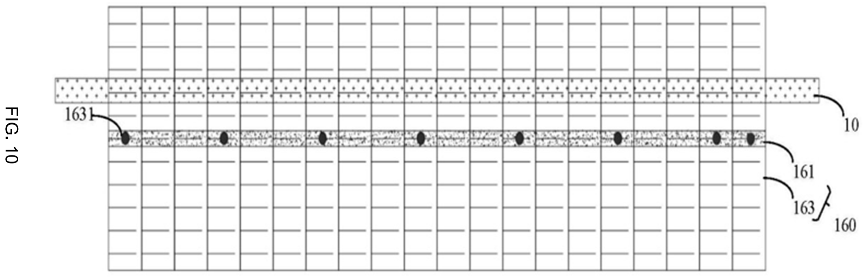

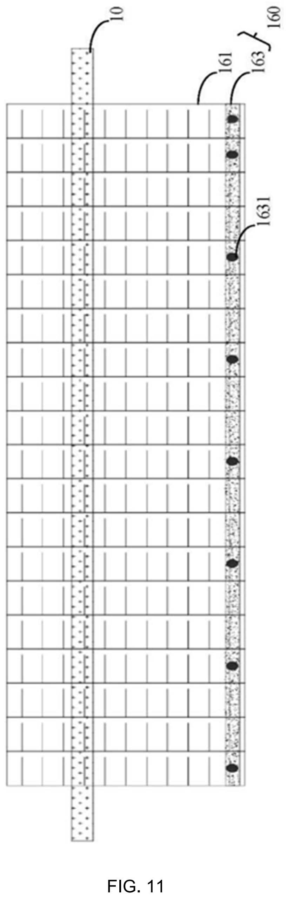

Specifically, as shown in FIGs. 9 to 11, FIG. 9 is a schematic diagram illustrating the laying of the adhesive film strip, in which the adhesive film strip 163 is laid on the surface of the cell string 161 at the edges on both sides along the direction of the long sides; FIG. 10 is a schematic diagram illustrating the laying of the adhesive film strip, in which the adhesive film strip 163 is laid on the surface of the cell string 161 in the middle portion along the direction of the long sides; FIG. 11 is a schematic diagram illustrating the laying of the adhesive film strip, in which the adhesive film strip 163 is laid on the surface of the cell string 161 at the edge on a single side along the direction of the long sides.

In this embodiment of the present disclosure, the preset positions of the adhesive film strip 163 are heated to melt and generate pre-fixed points 1631, so as to pre-fix the adhesive film strip 163 on the surface of the cell string 161. In this embodiment of the disclosure, the heating method may be soldering iron heating or light heating or bake-heating.

By pre-melting the local positions of the adhesive film strip 163 to generate pre-fixing points 1631, it is possible to pre-fix the laid adhesive film strip 163 on the surface of the cell string 161 and prevent relative displacement of the cells in a moving process of the cell string 161, for example, in a process of moving the cell string 161 to a heating box.

S132. Heat-crosslinking the cell string which is pre-fixed by the adhesive film strip to obtain a cell string unit

In this embodiment of the present disclosure, specifically, the cell string unit 160 is manufactured by placing the cell string 161 which is pre-fixed by the adhesive film strip 163 in a heating box for bake-crosslinking; or, the cell string unit 160 is manufactured by placing the cell string 161 which is pre-fixed by the adhesive film strip 163 in a light box for light crosslinking, wherein the heating time for bake-crosslinking is 8-10 minutes.

After bake-crosslinking, the cell string 161 has been fixed by the crosslinked adhesive film strip 163. At the same time, in the lamination process, the pre-crosslinked adhesive film strip 163 will not melt again to lose its effect of fixing the cells, and instead, will always maintain its effect of fixing the cells, thereby preventing the problem about non-uniform string spacing.

Alternatively, in another embodiment, when the adhesive film strip 163 is a pre-crosslinked material, since the adhesive film strip 163 has a certain crosslinking degree, the time for crosslinking the cell string 161 which is pre-fixed by the adhesive film strip 163 will be shortened, such that the production efficiency will be improved, wherein the pre-crosslinking degree of the pre-crosslinked material is 30%-50%, and the heating time for bake-crosslinking is 1-3 minutes. Specifically, the pre-crosslinking degree of the pre-crosslinked material can be, for example, 30%, 36%, 40%, 45%, and 50%.

Step S20. Providing a cover plate and laying a first encapsulation layer on one side of the cover plate

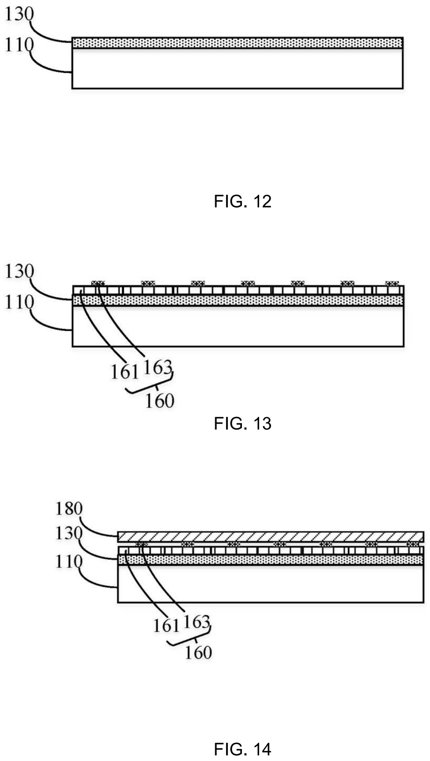

Specifically, as shown in FIG. 12, in this embodiment of the present disclosure, a cover plate 110 is provided to prepare for the subsequent manufacturing of a photovoltaic module, and a first encapsulation layer 130 is laid on one side of the cover plate 110, wherein the cover plate 110 may be a glass plate that allows light to pass through the front of the photovoltaic module. The first encapsulation layer 130 may be a solid single-layered or multi-layered adhesive film strip at room temperature, which is made of EVA and/or POE as main raw materials.

S30. Laying the cell string unit on one side of the first encapsulation layer away from the cover plate

Specifically, as shown in FIG. 13, in this embodiment of the present disclosure, the cell string unit 160 is laid on one side of the first encapsulation layer 130 away from the cover plate 110. The cell string unit 160 includes a cell string 161 and an adhesive film strip 163, wherein the adhesive film strip 163 is disposed on the surface of the cell string 161 at the edge to fix the cell string 161. In this embodiment of the present disclosure, the adhesive film strip 163 may be an EVA, POE, EPE, PVB, PP, epoxy resin film, acrylic film, or silicone film strip.

S40. Laying a second encapsulation layer on one side of the cell string unit away from the first encapsulation layer

Specifically, as shown in FIG. 14, in this embodiment of the present disclosure, a second encapsulation layer 180 is laid on one side of the cell string unit 160 away from the first encapsulation layer 130, wherein the second encapsulation layer 180 may be a solid single-layered or multi-layered adhesive film strip at room temperature, which is made of EVA and/or POE as main raw materials.

S50. Laying a back plate on one side of the second encapsulation layer away from the cell string unit to obtain a stacked structure

Specifically, as shown in FIG. 1, in this embodiment of the present disclosure, a back plate 190 is laid on one side of the second encapsulation layer 180 away from the cell string unit 160 to obtain the stacked structure 100.

S60. Laminating the stacked structure to obtain a laminated member

In this embodiment of the present disclosure, specifically, the stacked structure 100 is laminated at a preset temperature to obtain the laminated member, wherein the preset temperature may be 145°C.

It can be understood that in this embodiment of the present disclosure, when the adhesive film strip 163 is an EVA, POE, EPE, PVB, epoxy resin film, acrylic film or silicone film strip, since the melting point of the adhesive film strip 163 is lower than the lamination temperature, the adhesive film strip 163 is crosslinked in order to prevent the adhesive film strip 163 from melting again during lamination and thus losing its effect of fixing the cell string 161.

S70. Mounting a frame and junction box on the laminated member to obtain a photovoltaic modul

To sum up, in the method for manufacturing a photovoltaic module according to the present disclosure, the cell string 161 is fixed by laying the adhesive film strip 163 on the surface of the cell string 161, and meanwhile, the adhesive film strip 163 will not melt again during lamination because the adhesive film strip 163 is subjected to a crosslinking treatment or the adhesive film strip 163 with a melting point higher than the lamination temperature is selected, which prevents relative displacement of the cells and thereby avoids non-uniform string spacing of the cell string 161.

It should be understood that although the respective steps in the flowchart of FIG. 2 are shown in sequence according to the arrows, these steps are not necessarily executed in the sequence indicated by the arrows. Unless otherwise specified, these steps are not strictly limited in the sequence of execution, and they can be executed in other sequences. Moreover, at least some of the steps in FIG. 2 may include multiple sub-steps or multiple stages. These sub-steps or stages are not necessarily completed at the same time, but can be executed at different times. These sub-steps or stages are not necessarily executed sequentially, either, and they can be executed in turn or alternately with other steps or at least some of the sub-steps or stages of other steps.

The respective technical features of the above embodiments can be combined arbitrarily. For the sake of brevity, not all possible combinations of the technical features in the above embodiments are described. However, as long as the combinations of these technical features are not contradictory, they should be considered as falling within the scope of the disclosure herein.

The above embodiments are merely examples of several implementation manners of the present disclosure, and they should not be construed as limitations of the patent scope of the present disclosure although they are described specifically in details. It should be noted that those skilled in the art can also make various modifications and improvements without departing from the concept of the present disclosure, and all these various modifications and improvements fall within the protection scope of this disclosure. Therefore, the protection scope of the present disclosure shall be determined by the accompanying claims.

## Claims

1. A method for manufacturing a photovoltaic module, comprising:
manufacturing a cell string unit (160);
providing a cover plate (110) and laying a first encapsulation layer (130) on one side of the cover plate (110);
laying the cell string unit (160) on one side of the first encapsulation layer (130) away from the cover plate (110);
laying a second encapsulation layer (180) on one side of the cell string unit (160) away from the first encapsulation layer (130);
laying a back plate (190) on one side of the second encapsulation layer away (180) from the cell string unit (160) to obtain a stacked structure (100);
laminating the stacked structure (100) to obtain a laminated member;
mounting a frame and a junction box on the laminated member to obtain a photovoltaic module;
wherein the manufacturing a cell string unit (160) includes:
providing a cell string (161);
laying an adhesive film strip (163) on a surface of the cell string (161);
heat-crosslinking the cell string (161) laid with the adhesive film strip (160) to obtain the cell string unit (160).

2. The method for manufacturing a photovoltaic module according to claim 1, wherein the adhesive film strip (163) is laid on the surface of the cell string (161) in the middle portion along the direction of the long sides; or
the adhesive film strip (163) is laid on the surface of the cell string (161) at the edges on both sides along the direction of the long sides; or
the adhesive film strip (163) is laid on the surface of the cell string (161) at the edge on a single side along the direction of the long sides.

3. The method for manufacturing a photovoltaic module according to claim 1, wherein the heat-crosslinking of the cell string (161) laid with the adhesive film strip (163) includes:
heating the preset positions of the adhesive film strip (163) to pre-fix the adhesive film strip (163) on the surface of the cell string (161);
heat-crosslinking the cell string (161) which is pre-fixed by the adhesive film strip (163).

4. The method for manufacturing a photovoltaic module according to claim 3, wherein the manner for pre-fixing is soldering iron heating or light heating or bake-heating.

5. The method for manufacturing a photovoltaic module according to claim 3, wherein the manner for heat-crosslinking is bake-crosslinking or light crosslinking.

6. The method for manufacturing a photovoltaic module according to claim 5, wherein the adhesive film strip (163) is an EVA, POE, EPE, PVB, epoxy resin film, acrylic film, or silicone film strip, and the heating time for bake-crosslinking is 8-10 minutes.

7. The method for manufacturing a photovoltaic module according to claim 5, wherein the adhesive film strip (163) is a pre-crosslinked material which preferably has a pre-crosslinking degree of 30%-50%, and the heating time for bake-crosslinking is 1-3 minutes.

8. The method for manufacturing a photovoltaic module according to claim 1, wherein the adhesive film strip (163) is a composite adhesive film strip.

9. A stacked structure (100), comprising a cover plate (190), a first encapsulation layer (130), a cell string unit (160), a second encapsulation layer (180), and a back plate (190), wherein
the first encapsulation layer (130) is disposed on one side of the cover plate (110);
the cell string unit (160) is disposed on one side of the first encapsulation layer (130) away from the cover plate (110);
the second encapsulation layer (180) is disposed on one side of the cell string unit (160) away from the first encapsulation layer (130);
the back plate (190) is disposed on one side of the second encapsulation layer (180) away from the cell string unit (160);
the cell string unit (160) including a cell string (161) and an adhesive film strip (163), wherein the adhesive film strip (163) is disposed on a surface of the cell string (161) to fix the cell string (161).

10. A photovoltaic module, which is manufactured by subjecting the stacked structure (100) of claim 9 to a lamination treatment to obtain a laminated member and then mounting a junction box and a frame.
